# EUROPEAN PATENT SPECIFICATION

(11) **EP 1 420 299 B1**
(45) Date of publication and mention of the grant of the patent: **05.01.2011**
(21) Application number: 03257071.5
(22) Date of filing: 10.11.2003
(51) Int. Cl.: G03F 7/20

(54) **Immersion lithographic apparatus and device manufacturing method**
Lithographischer Apparat mit Immersion und Verfahren zur Herstellung einer Vorrichtung
Appareil lithographique à immersion et méthode de fabrication d'un dispositif

(30) Priority: 12.11.2002 EP 02257822; 09.06.2003 EP 03253636; 26.06.2003 EP 03254059
(43) Date of publication of application: 19.05.2004
(73) Proprietor: ASML Netherlands B.V., 5504 DR Veldhoven (NL)
(72) Inventor: Lof, Joeri, 5616 BW Eindhoven (NL); Derksen, Antonius Theodorus Anna Maria, 5623 CB Eindhoven (NL); Hoogendam, Christiaan Alexander, 5509 NC Veldhoven (NL); Loopstra, Erik Roelof, 5591 BA Heeze (NL); Mulkens, Johannes Catharinus Hubertus, 6211 LP Maastricht (NL); Straaijer, Alexander, 5644 KK Eindhoven (NL); Streefkerk, Bob, 5038 PE Tilburg (NL); Donders, Sjoerd Nicolaas Lambertus, 5211 HN s'Hertogenbosch (NL); Mertens, Jeroen Johannes Sophia Maria, 5525 BC Duizel (NL); Sengers, Timotheus Franciscus, 5236 SM s'-Hertogenbosch (NL)
(74) Representative: Corcoran, Gregory Martin Mason

(56) References cited:
- EP-A1- 1 571 697
- WO-A-99/49504
- WO-A2-2004/090577
- WO-A2-2004/093130
- DD-A1- 224 448
- PATENT ABSTRACTS OF JAPAN vol. 1999, no. 02, 26 February 1999 (1999-02-26) -& JP 10 303114 A (NIKON CORP), 13 November 1998 (1998-11-13)

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a localized area liquid supply system for providing an immersion liquid to a space between the final element of said projection system and said substrate on only a localized area of said substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

It has been proposed to immerse the substrate in the lithographic projection apparatus in a liquid having a relatively high refractive index, e.g. water so as to fill a space between the final element of the projection system and the substrate. The point of this is to enable imaging of smaller features as the exposure radiation will have a shorter wavelength in the liquid. (The effect of the liquid may also be regarded as increasing the effective NA of the system and also increasing the depth of focus.)

However, submersing the substrate or substrate and substrate table in a bath of liquid (see for example US 4,509,852, means that there is a large body of liquid that must be accelerated during a scanning exposure. This requires additional or more powerful motors and turbulence in the liquid may lead to undesirable and unpredictable effects.

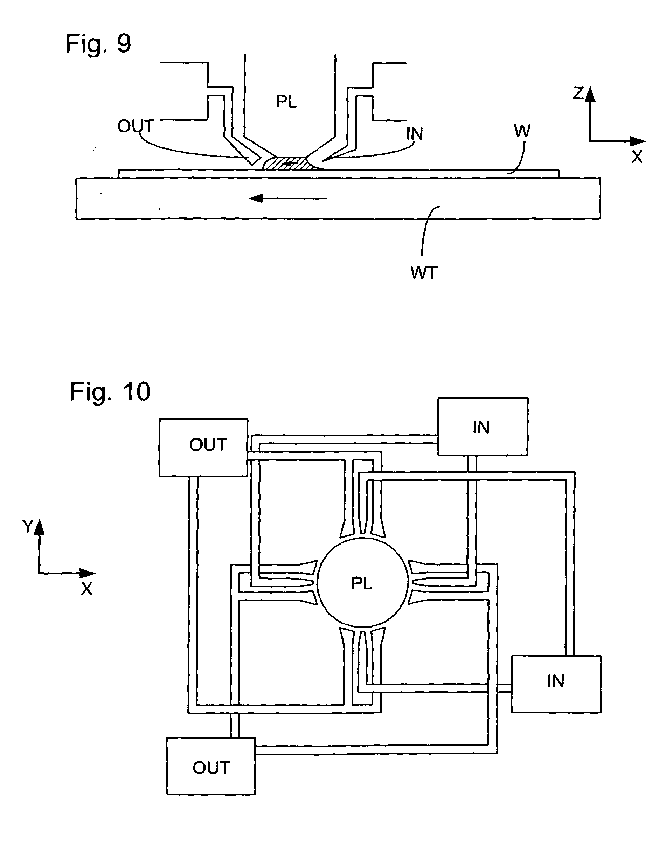

One of the solutions proposed is for a liquid supply system to provide liquid on only a localized area of the substrate and inbetween the final element of the projection system and the substrate (the substrate generally has a larger surface area than the final element of the projection system). One way which has been proposed to arrange for this is disclosed in WO 99/49504 (on which the precharacterising section of claim 1 is based). As illustrated in Figures 9 and 10, liquid is supplied by at least one inlet IN onto the substrate, preferably along the direction of movement of the substrate relative to the final element, and is removed by at least one outlet OUT after having passed under the projection system. That is, as the substrate is scanned beneath the element in a -X direction, liquid is supplied at the +X side of the element and taken up at the -X side. Figure 9 shows the arrangement schematically in which liquid is supplied via inlet IN and is taken up on the other side of the element by outlet OUT which is connected to a low pressure source. In the illustration of Figure 9 the liquid is supplied along the direction of movement of the substrate relative to the final element, though this does not need to be the case. Various orientations and numbers of in- and out-lets positioned around the final element are possible, one example is illustrated in Figure 10 in which four sets of an inlet with an outlet on either side are provided in a regular pattern around the final element.

With such and other arrangements for providing liquid on only a localized area of the substrate, the substrate itself acts to contain the liquid of the liquid supply system in a space between the final element of the projection system and the substrate. If the substrate is removed (for example during substrate exchange) and no other measures are taken, the liquid will run out of the liquid supply system. Clearly this is a situation which is to be avoided. The liquid can be removed from the space before the substrate is moved. However, as the residue of liquid which is inevitably left behind when the liquid supply system is emptied of liquid, dries, drying spots may be left behind on elements of the projection system which were immersed in the liquid during exposure. This is clearly detrimental to the continuing high performance of the projection system. Also, on refilling the space with liquid, it may be hard to avoid the formation of bubbles. Filling of the space with liquid will also take time and may reduce through-put time.

EP-A-1,571,697 which is citable under Article 54(3) EPC discloses a lithographic projection apparatus as specified in the opening paragraph and including a shutter member for keeping the final element in contact with the liquid when the substrate is moved away from under the projection system by covering the aperture of the seal member to prevent liquid escaping through the aperture out of the liquid supply system.

WO 2004/090577 which is citable under Article 54(3) EPC discloses a lithographic apparatus as specified in the opening paragraph and further comprising a shutter member for keeping the final element in contact with liquid when the substrate is moved away from under the projection system by covering the aperture of the seal member to prevent liquid escaping through the aperture out of the liquid supply system in which the shutter member is separable from the remainder of the apparatus.

It is an object of the present invention to provide a lithographic projection apparatus in which immersion lithography can be performed and in which removing liquid from the projection lens during substrate exchange can be avoided or reduced.

This and other objects are achieved according to the invention in a lithographic apparatus as specified in the opening paragraph, **characterised in that** said liquid supply system comprises a seal member which extends along at least part of the boundary of said space for containing said liquid and which forms an aperture for the projection beam to pass through, and in that said apparatus further comprises a shutter member for keeping said final element in contact with liquid when said substrate is moved away from under said projection system by covering the aperture of said seal member to prevent liquid escaping through the aperture out of the liquid supply system, and wherein said shutter member is separable from the remainder of said apparatus, and said apparatus further comprises means for releasably attaching said shutter member to said seal member.

In this way drying marks on the final element of the projection system can be avoided. This solution is ideal for a localised area liquid supply system which provides immersion liquid to only a localised area of the substrate. One arrangement is to provide the shutter member positionable on a side of said liquid supply system opposite said projection system such that said immersion liquid can be confined in said liquid supply system and between said projection system and said shutter member.

With this arrangement the shutter member can be moved under the liquid supply system after exposure of the substrate thereby to contain the liquid. The substrate may then be moved from the substrate table without liquid from the liquid supply system being lost, because the shutter member takes the place of the substrate and is of a size equal to or greater than the localised area so that no liquid can escape between the liquid supply system and the shutter member.

A seal, such as a gas seal, which can also be used to seal a seal member extending along at least a part of the boundary of said space for containing said liquid and forming an aperture for said projection beam to pass through to the substrate during exposure, can remain activated to seal between the liquid supply system and the shutter member. The shutter member blocks the aperture. Alternatively, the shutter member may be raised relative to the seal member to abut the seal member and the seal can then be de-activated.

In an embodiment, the shutter member is movable relative to the remainder of the apparatus. That is, the shutter member is relatively small, perhaps shaped like a plate, and not permanently attached to other parts of the apparatus. The substrate table can be moved completely away from the liquid supply system after exposure as the shutter member is positioned over the liquid supply system and is independent of the substrate table. It is preferred that the shutter member is carried by the substrate table during exposure and to this end the shutter member and/or the substrate table has or have means for releasably holding the shutter member to the substrate table. The means for releasably attaching or the means for releasably holding may comprise magnetic means for generating the force required for attaching or holding. Alternatively, those means may comprise a vacuum outlet for attracting the shutter member to the substrate table and/or the liquid supply system. In the case of the means for releasably attaching, use may be made of a gas seal for sealing between the liquid supply system and the substrate during exposure to provide the force for attaching the shutter member to the liquid supply system.

In another embodiment the liquid supply system comprises means for removing liquid from the space and a gas inlet for providing flushing in said space. This might be required every now and again due to contamination of the liquid or perhaps during a long term shut down of the apparatus. In this way, liquid may be removed from the space and the space can be flushed with gas. The shutter member is then attached to the aperture to protect the lens.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- using a liquid supply system to provide an immersion liquid at least partly filling a space between the final element of a projection system used in said step of projecting and a said substrate on only a localized area of said substrate wherein said liquid supply system comprise a seal member which extends along at least part of a boundary of said space for containing said liquid and which forms an aperture for the projection beam to pass through;
- projecting the patterned beam of radiation onto a target portion of the layer of
   - radiation-sensitive material;
   - moving said substrate away from under said projection system; and maintaining said final element in contact with liquid after said substrate has been moved away from under said projection system by covering the aperture of said seal member using a shutter member, which is separable from the remainder of the apparatus,
and releasably attaching the shutter member to the seal member.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm).

Embodiments of the invention will now be described, by way of example only, with reference to the accompanying schematic drawings in which:
Figure 1 depicts a lithographic projection apparatus according to an embodiment of the invention;
Figure 2 depicts the liquid reservoir of the first embodiment of the invention;
Figure 3 depicts the liquid reservoir and substrate table;
Figure 4 depicts the liquid reservoir, substrate table and shutter member of the first embodiment of the invention;
Figure 5 depicts the liquid reservoir, substrate table and shutter member of the first embodiment of the present invention;
Figure 6 illustrates an alternative arrangement of the first embodiment of liquid reservoir, substrate table and shutter member of the present invention;
Figure 7 illustrates a second embodiment of the present invention;
Figure 8 illustrates one variant of shutter member;
Figure 9 illustrates an alternative liquid supply system according to an embodiment of the invention; and
Figure 10 illustrates, in plan, the system of Figure 9.

In the Figures, corresponding reference symbols indicate corresponding parts.

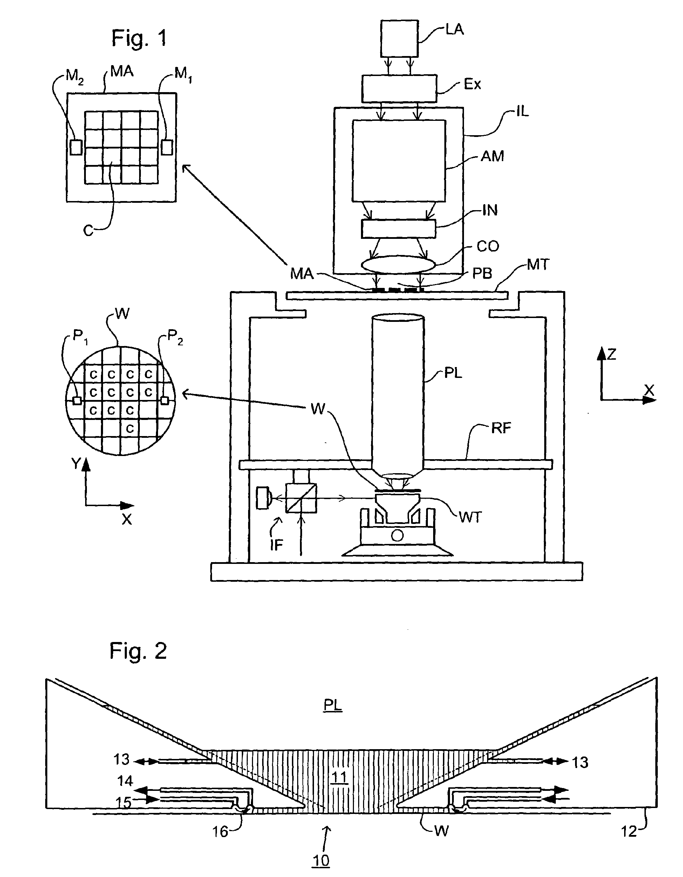

Figure 1 schematically depicts a lithographic projection apparatus according to a particular embodiment of the invention. The apparatus comprises:
a radiation system Ex, IL, for supplying a projection beam PB of radiation (*e.g.* UV radiation), which in this particular case also comprises a radiation source LA;
a first object table (mask table) MT provided with a mask holder for holding a mask MA (*e.g.* a reticle), and connected to first positioning means for accurately positioning the mask with respect to item PL;
a second object table (substrate table) WT provided with a substrate holder for holding a substrate W (*e.g*. a resist-coated silicon wafer), and connected to second positioning means for accurately positioning the substrate with respect to item PL;
a projection system ("lens") PL (*e*.*g*. a refractive lens system) for imaging an irradiated portion of the mask MA onto a target portion C (*e.g*. comprising one or more dies) of the substrate W.
As here depicted, the apparatus is of a transmissive (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g*. an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i*.*e*. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed ν, so that the projection beam PB is caused to scan over a mask image; concurrently, the substrate table WT is simultaneously moved in the same or opposite direction at a speed *V* = *M*ν, in which *M* is the magnification of the lens PL (typically, *M =* 1/4 or 1/5). In this manner, a relatively large target portion C can be exposed, without having to compromise on resolution.

Figure 2 shows a liquid reservoir 10 between the projection system PL and the substrate W which is positioned on the substrate stage WT. The liquid reservoir 10 is filled with a liquid 11 having a relatively high refractive index, e.g. water, provided via inlet/outlet ducts 13. The liquid has the effect that the radiation of the projection beam is a shorter wavelength in the liquid than in air or in a vacuum, allowing smaller features to be resolved. It is well known that the resolution limit of a projection system is determined, inter alia, by the wavelength of the projection beam and the numerical aperture of the system. The presence of the liquid may also be regarded as increasing the effective numerical aperture. Furthermore, at fixed numerical aperture, the liquid is effective to increase the depth of focus.

The reservoir 10 forms a preferably contactless seal to the substrate W around the image field of the projection lens PL so that the liquid is confined to fill the space between the substrate's primary surface, which faces the projection system PL, and the final optical element of the projection system PL. The reservoir is formed by a seal member 12 positioned below and surrounding the final element of the projection lens PL. Thus, the liquid supply system provides liquid on only a localized area of the substrate. The seal member 12 forms part of the liquid supply system for filling the space between the final element of the projection system and the substrate W with a liquid. This liquid is brought into the space below the projection lens and within the seal member 12. The seal member 12 extends a little above the bottom element of the projection lens and the liquid rises above the final element so that a buffer of liquid is provided. The seal member 12 has an inner periphery that at the upper end closely conforms to the shape of the projection system or the final elements thereof and may, e.g. be round. At the bottom the inner periphery forms an aperture which closely conforms to the shape of the image field, e.g. rectangular, though this is not necessarily so. The projection beam passes through this aperture.

The liquid 11 is confined in the reservoir 10 by a seal device 16. As illustrated in Figure 2, the seal device is a contactless seal, i.e. a gas seal. The gas seal is formed by gas, e.g. air or synthetic air, provided under pressure via inlet 15 to the gap between seal member 12 and substrate W and extracted by first outlet 14. The over pressure on the gas inlet 15, vacuum level on the first outlet 14 and the geometry of the gap are arranged so that there is a high-velocity air flow inwards towards the optical axis of the apparatus that confines the liquid 11. As with any seal, some liquid is likely to escape, for example up the first outlet 14.

Figures 9 and 10 also depict a liquid reservoir defined by inlet(s) IN, outlet(s) OUT, the substrate W and the final element of projection lens PL. Like the liquid supply system of Figure 2 the liquid supply system illustrated in Figures 9 and 10, comprising inlet(s) IN and outlet(s) OUT, supplies liquid to a space between the final element of the projection system and a localized area of the primary surface of the substrate.

As can be seen from Figures 2 and 9, during exposure, the substrate W provides the bottom wall of the liquid reservoir thereby containing the liquid in a space between the projection system PL and the substrate W.

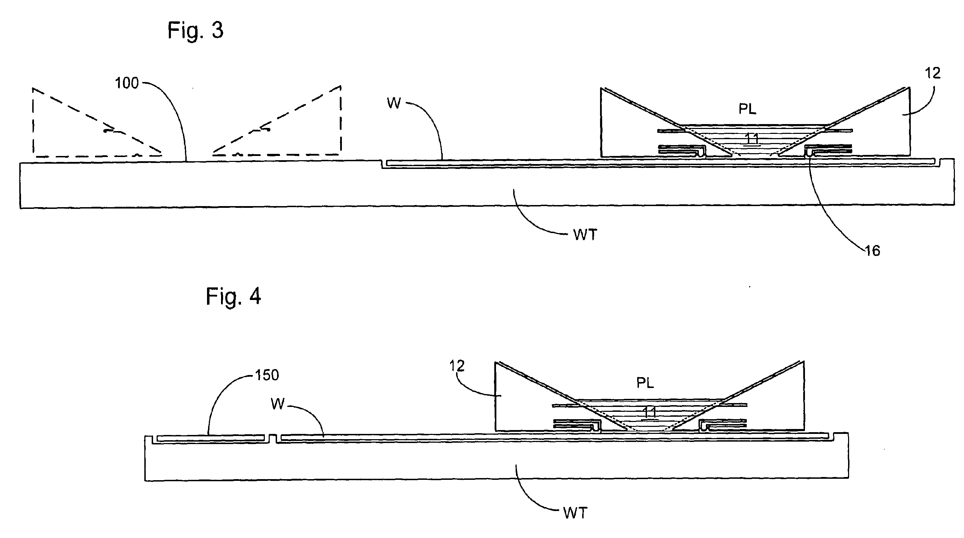

Figure 3 shows the substrate table WT which can be used to avoid the necessity of emptying liquid from the liquid reservoir once the substrate W has been imaged and before being unloaded from the substrate table WT. A shutter member 100 (also termed a cover plate, edge seal member, gap seal means or member or intermediary plate) is provided for this purpose. The shutter member 100 is a surface other than a substrate surface, in this case an upper (as illustrated) primary surface of the substrate table WT which is substantially co-planar with the upper primary surface of the substrate W and is closely adjacent to the edge of the substrate W. The area of the shutter member 100 is large enough so that if the substrate table WT is moved such that the projection system PL and seal member 12 are positioned over the shutter member 100 (as illustrated in dotted lines) the shutter member blocks the entire aperture of the seal member 12 to prevent liquid escaping through the aperture. In this position, the substrate W can be removed from the substrate table WT using usual substrate handling equipment. If the edge of the substrate W is close to the edge of the shutter member 100 (i.e. the gap between the substrate W, when positioned on the pimple table or chuck or whatever holds the substrate W to the substrate table WT, and the edge of the shutter member 100 is relatively small), there will be no sudden loss of liquid as the edge of the substrate moves under the aperture in the seal member 12. The substrate table WT may be raised towards the projection system to block the aperture so that the seal means 16 can be deactivated.

### Embodiment 1

An embodiment of the present invention is illustrated in Figure 4 and is an improvement over the system of Figure 3 in that it allows the substrate table WT to be moved completely away from the projection system PL and seal member 12 for the substrate W to be removed from the substrate table WT and a new substrate to be placed on the substrate table WT. Thus it can be used, for example, with dual stage machines.

In the embodiment, a shutter member 150 is in the form of a plate with a primary cross-sectional area larger than that of the localised area or aperture in the seal member 12. The shape of the shutter member 150 may be any shape so long as it covers the aperture. The shutter member 150 is not a substrate and is movable relative to both the substrate table WT and the seal member 12 and may be attached to the seal member 12 by any means, two examples of which are described below.
After imaging of the substrate W, the substrate table WT is moved so that the shutter member 150 is positioned under the aperture of the seal member 12. The gap between the substrate W and the top surface of the substrate table WT and the gap between the top of the substrate table WT and the top surface of the shutter member 150 are small so there is no catastrophic loss of liquid from the reservoir 10 whilst passing over the gaps. The top (primary) surfaces (as illustrated) of the substrate W, substrate table WT between the substrate W and the shutter member 150 and the shutter member 150 are arranged to be substantially co-planar. Once positioned under the projection system PL, the shutter member 150 is attached to the bottom of the seal member 12 to cover the aperture. The seal member 12 is then moved away from the substrate table WT in the Z direction (the direction of the optical axis) or the substrate table WT is lowered away from the seal member 12. The substrate table WT may then be moved out of the way to a place where the substrate W may be exchanged. Once a new substrate has been loaded onto the substrate table WT and any necessary alignment or other measurements (e.g. leveling) have been made (e.g. in a dual stage machine), the substrate table WT is moved to a position where the shutter member 150 may be re-positioned onto the substrate table WT and then the substrate table WT is moved such that the substrate W is positioned under the projection system PL so that exposure can begin.

Of course it may be possible to provide the shutter member 150 on an object in the lithographic apparatus other than the substrate table WT. For example on a robotic arm can be provided which moves to position the shutter member under the projection system after exposure.

The position of the shutter member 150 may drift over time so that means for centering or at least keeping a track of the position of the shutter member is useful. This may be a mechanical or optical or electrical or other type of sensor on the landing area of the shutter member on the substrate table WT and/or such a sensor provided on the liquid supply system (e.g. seal member 12). For such a system, a quartz shutter member is preferred, especially for an apparatus which exposes at 193 nm. Alternatively or additionally a through lens sensor and detector that uses a reflected signal from a marker on the shutter member 500 which signal is coupled via a beam splitter to the detector is provided. Such a system can be used whilst the substrate stage WT is moving, thereby improving through put. Alternatively or additionally, the position of the shutter member may be measured by an optical sensor on the substrate table WT. In this case a mark is applied to the underside or top side of the shutter member 150 (e.g. a transmissive pattern for the radiation wavelength) and the position of the shutter member 150 may then be measured by a sensor on the substrate table WT whilst the projection system PL exposes the mark. The mark is transmissive to radiation from the projection system (or another radiation source) and a transmission image sensor (TIS) or spot-sensor which is on the substrate table WT can then be used to measure displacement of the shutter member when attached to the liquid supply system. Depending on the mark design on the shutter member, the transmission image sensor (TIS) or spot sensor that are already available in the substrate table WT can be used. In this way, the apparatus can keep a record of the drift in position of the shutter member over time by sensing the position regularly, for example every cycle or perhaps only every ten or one hundred cycles or when is deemed necessary. Any necessary adjustments can then be made.

Alternatively, a quad cell sensor can be mounted at the center of the shutter member 150. An absorbing (or transmissive) spot is positioned in the center of the mirror block so that when the shutter member 150 is positioned on the substrate stage WT after use, its position can be measured. The quad cell sensor is made up of four light sensitive cells in a square. When the light beam is on center the outputs of the four cells are equal. If the sensor drifts to one side, the outputs of the cells on that side increase compared to the cells or the other side. Thus any deviation from the preferred position can be corrected the next time the shutter member 150 is attached to the liquid supply system.

Another way of centering the shutter member 150, which does not involve complicated positional sensing, is to provide the shutter member 150 with a shape which is self centering when picked up by the liquid supply system. A suitable example might be a thicker shutter member 150 than is required with a conical edge that locates in the aperture of the liquid supply system.

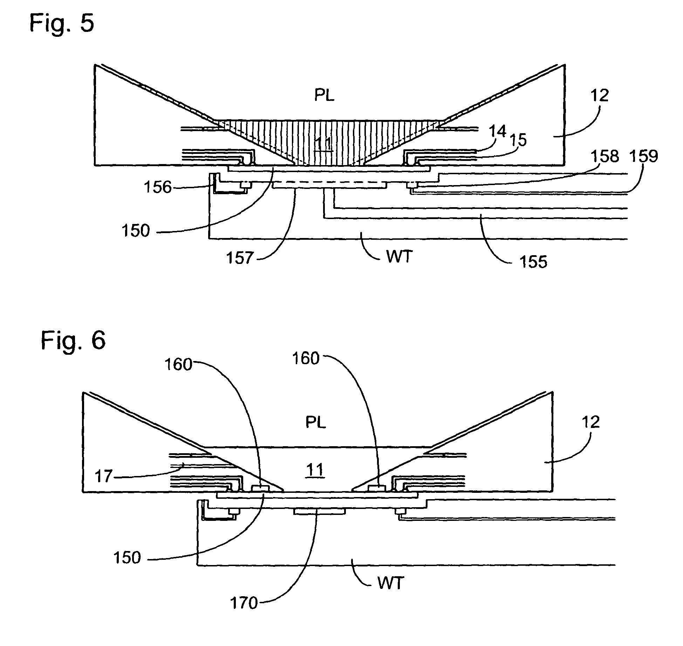

Figure 5 illustrates one way of attaching the shutter member 150 to the underside of the seal member 12. This method usefully makes use of the seal 16 of the seal member 12. The outlet 14 is energized and the (gas) inlet 15 is not energized when the shutter member 150 is positioned under the aperture. The vacuum provided in the outlet 14 is enough to attract the shutter member 150 to be clamped to the bottom of the seal member 12 thereby sealing the aperture. When the shutter member 150 is replaced on the substrate table WT, the seal 16 can be reactivated to operate as normal and the substrate table WT moved to the expose position. The shutter member 150 may be held on the substrate table WT by use of vacuum outlet 157 connected to a vacuum source through a duct 155. To avoid or reduce immersion liquid leakage under the shutter member 150, a (annular) channel 158 is provided around the vacuum outlet 157. The channel 158 is connected via a duct 159 to a vacuum source so that any liquid is removed by the flow of gas through the channel 158 caused by the vacuum. It might be advantageous to have a flow of gas in the channel 158, even when the shutter member 150 is in place. To this end a duct 156 open at a surface, for example the top surface of the substrate table WT, and connected to the channel 158 can be provided on a side substantially opposite to the duct 159 leading to the vacuum source. In the second embodiment, the seal 16 need not be activated whilst the shutter member 150 is positioned to cover the aperture but preferably is activated.

An alternative means for holding the shutter member 150 to the substrate table WT and means for attaching the shutter member 150 to the seal member 12, is illustrated in Figure 6. In this embodiment the shutter member 150 is made of a ferromagnetic material (or partly of ferromagnetic material by making an assy) such that magnets 160, 170 (preferably electromagnets for easy attachment and detachment) positioned on the seal member 12 and substrate table WT may be used to hold the shutter member 150 in position against the seal member 12 and substrate table WT respectively. By keeping seal 16 activated, loss of liquid can be minimized. The channel 158 and duct 156, 159 arrangement described in relation to the Figure 5 embodiment may also be employed in the Figure 6 embodiment to reduce or alleviate liquid leakage under the shutter member 150.

The shutter member 150 should always be held by at least one of the substrate table WT and the seal member 12 so that the shutter member 150 is always under control.

As it is further illustrated in Figure 6, it may be desirable to remove liquid 11 from the reservoir 10 during substrate exchange. This is done by extracting the liquid either through the outlet 14 or the outlet duct 13 and then flushing the space with gas provided through a further gas inlet 17. This might be done for maintenance and the lens may need to be cleaned after this process.

Of course, features from both Figures 5 and 6 can be combined.

### Embodiment 2

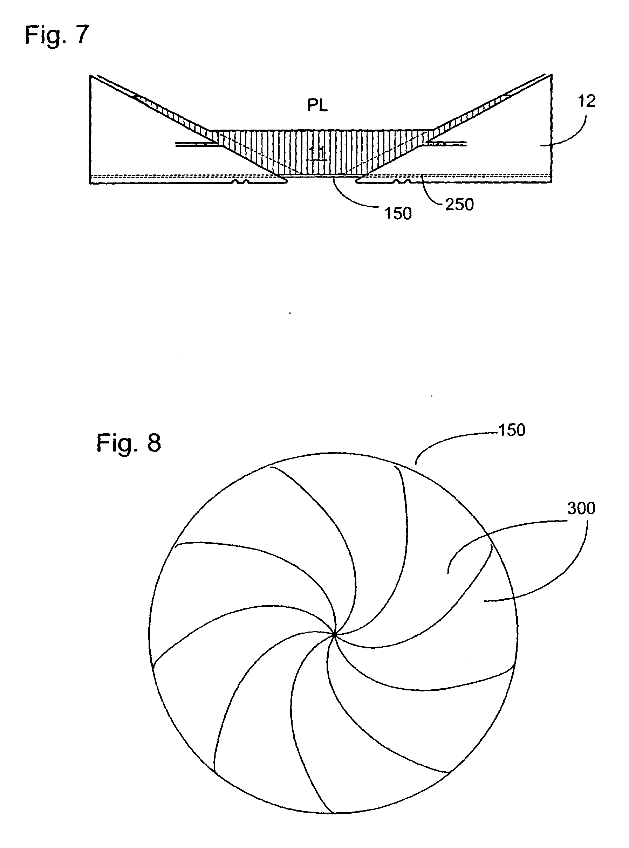

The second embodiment is the same as the first embodiment except as described below. The second embodiment is illustrated in Figure 7 and differs from the first embodiment in that the shutter member 150 is placed within the seal member 12. The similarity with the first embodiment lies in the fact that the shutter member is separate from the substrate table WT. The shutter member 150 can be moved from any resting position to block the aperture by being moved under the projection system PL through channels 250 in the seal means 12.
The shutter member 150 is separate from the seal means 12 and moved into the seal means 12 at the required time by a robotic arm, for example.

A shutter member not in accordance with the present invention may have a series of leafs 300 as illustrated in Figure 8. The leafs 300 work like a shutter of a camera in that the leafs can be moved such that they do not obstruct the aperture but, when the plurality of leafs are moved to abut at the center of the aperture they thereby block the aperture.

The invention has been described above in relation to the seal member variant of the localised area solution. However, the invention as described above is equally applicable to any other type of liquid supply for example those disclosed in EP-A-1,498,778 or European Patent application No.03256643.2 or to the variant illustrated in Figures 9 and 10. For example, in the case of a shutter member 150 moveable relative to both the substrate table WT and the projection system PL, means for attaching the shutter member below the in-and outlets IN, OUT may be attached to the members forming the in-and-out-lets IN, OUT, or to a separate structure. Additionally or instead, the vacuum of the outlets OUT can be used to attract the shutter member to the IN-and outlets IN, OUT and thereby seal the aperture. It may be desirable to use a non-flat shutter member e.g. one with a protruding border so that any drips of liquid from the various in-and out-lets are contained. Any system for generating a force can be used for the means for attaching, including low pressure sources, magnetic means, mechanical means, electro static means etc..

Whilst specific embodiments of the invention have been described above, it will be appreciated that the invention may be practiced otherwise than as described without departing from the scope of the claims set out below. The description is not intended to limit the invention.

## Claims

1. A lithographic projection apparatus comprising:
- a radiation system (LA,Ex,IL) for providing a projection beam (PB) of radiation;
- a support structure (MT) for supporting patterning means (MA), the patterning means serving to pattern the projection beam according to a desired pattern;
- a substrate table (WT)for holding a substrate (W);
- a projection system (PL) for projecting the patterned beam onto a target portion of the substrate; and
- a localized area liquid supply system for providing an immersion liquid to a space between the final element of said projection system and said substrate on only a localized area of said substrate, **characterised in that**:
- said liquid supply system comprises a seal member (12) which extends along at least part of the boundary of said space for containing said liquid and which forms an aperture for the projection beam to pass through, and **in that**
said apparatus further comprises a shutter member (100,150) for keeping said final element in contact with liquid when said substrate is moved away from under said projection system by covering the aperture of said seal member to prevent liquid escaping through the aperture out of the liquid supply system, and wherein said shutter member is separable from the remainder of said apparatus, and said apparatus further comprises means for releasably attaching (14,15,16,160) said shutter member to said seal member.

2. The apparatus according to claim 1, wherein said shutter member is positionable on a side of said supply system opposite said projection system such that said immersion liquid can be confined in said seal member and between said projection system and said shutter member.

3. The apparatus according to claim1 or 2, wherein said shutter member and/or said substrate table has or have means for releasably holding (157,170) said shutter member to said substrate table.

4. The apparatus according to claim 3, wherein said means for releasably holding comprise magnetic means.

5. The apparatus according to claim 3 or 4, wherein said means for releasably holding comprise a vacuum outlet for attracting said shutter member to said substrate table.

6. The apparatus according to claim 1, 2, 3, 4 or 5, wherein said means for releasably attaching comprise magnetic means.

7. The apparatus according to any one of the preceding claims, wherein said means for releasably attaching comprise a vacuum outlet for attracting said shutter member to said liquid supply system.

8. The apparatus according to claim 5 or 7, wherein said seal member comprises a low pressure source (14) for sealing between said seal member and said substrate or said shutter member, said low pressure source (14) forming at least part of said means for releasably attaching.

9. The apparatus according to any one of claims 2 to 8, wherein, in a stowed position, said shutter member has a primary surface substantially co-planar with a surface of said substrate facing said final element.

10. The apparatus according to any one of claims 1 to 9, wherein said shutter member comprises a mark for guiding said shutter member.

11. The apparatus according to claim 10, further comprising a sensor for measuring the position of said shutter member using said mark.

12. The apparatus according to any one of claims 1 to 11, wherein said shutter member (150), when confining said liquid, is positioned in said seal member.

13. The apparatus, according to any one of the preceding claims, wherein said liquid supply system comprises means for removing liquid from said space and a gas inlet (17) for providing flushing gas in said space.

14. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- using a liquid supply system to provide an immersion liquid at least partly filling a space between the final element of a projection system used in said step of projecting and a said substrate on only a localized area of said substrate wherein said liquid supply system comprise a seal member (12) which extends along at least part of a boundary of said space for containing said liquid and which forms an aperture for the projection beam to pass through;
- projecting the patterned beam of radiation onto a target portion of the layer of radiation-sensitive material;
- moving said substrate away from under said projection system;
and maintaining said final element in contact with liquid after said substrate has been moved away from under said projection system by covering the aperture of said seal member using a shutter member, which is separable from the remainder of the apparatus, and releasably attaching the shutter member to the seal member.

15. The method according to claim 14, wherein said final element is maintained in contact with said immersion liquid by positioning said shutter member on a side of said liquid supply system opposite to said projection system such that said immersion liquid is confined in said seal member and between said projection system and said shutter member.

## Patentansprüche

1. Ein lithographisches Projektionsgerät, das Folgendes beinhaltet:
- ein Strahlungssystem (LA, Ex, IL) zum Bereitstellen eines Projektionsstrahls (PB) aus Strahlung;
- eine Stützstruktur (MT) zum Stützen eines Musteraufbringungsmittels (MA), wobei das Musteraufbringungsmittel dazu dient, den Projektionsstrahl gemäß einem gewünschten Muster zu mustern;
- einen Substrattisch (WT) zum Halten eines Substrats (W);
- ein Projektionssystem (PL) zum Projizieren des gemusterten Strahls auf einen Zielabschnitt des Substrats und
- ein Flüssigkeitszufuhrsystem für einen örtlich begrenzten Bereich, um einem Raum zwischen dem Endelement des Projektionssystems und dem Substrat auf nur einem örtlich begrenzten Bereich des Substrats eine Immersionsflüssigkeit bereitzustellen, **dadurch gekennzeichnet, dass**:
das Flüssigkeitszufuhrsystem ein Dichtungsteil (12) beinhaltet, das sich entlang mindestens einem Teil der Grenze des Raums erstreckt, um die Flüssigkeit einzugrenzen, und das eine Öffnung für das Durchgehen des Projektionsstrahls bildet, und **dadurch**, dass
das Gerät ferner ein Verschlussteil (100, 150) beinhaltet, um das Endelement in Kontakt mit der Flüssigkeit zu behalten, wenn das Substrat von unter dem Projektionssystem wegbewegt wird, indem die Öffnung des Dichtungsteils abgedeckt wird, um ein Entweichen der Flüssigkeit durch die Öffnung aus dem Flüssigkeitszufuhrsystem heraus zu verhindern, und wobei das Verschlussteil von dem Rest des Geräts getrennt werden kann und das Gerät ferner ein Mittel zum lösbaren Anbringen (14, 15, 16, 160) des Verschlussteils an dem Dichtungsteil beinhaltet.

2. Gerät gemäß Anspruch 1, wobei das Verschlussteil auf einer Seite des Zufuhrsystems, die dem Projektionssystem entgegengesetzt ist, positionierbar ist, so dass die Immersionsflüssigkeit in dem Dichtungsteil und zwischen dem Projektionssystem und dem Verschlussteil eingedämmt werden kann.

3. Gerät gemäß Anspruch 1 oder 2, wobei das Verschlussteil und/oder der Substrattisch ein Mittel zum lösbaren Halten (157, 170) des Verschlussteils an dem Substrattisch aufweist oder aufweisen.

4. Gerät gemäß Anspruch 3, wobei das Mittel zum lösbaren Halten ein Magnetmittel beinhaltet.

5. Gerät gemäß Anspruch 3 oder 4, wobei das Mittel zum lösbaren Halten einen Vakuumauslass zum Anziehen des Verschlussteils an den Substrattisch beinhaltet.

6. Gerät gemäß Anspruch 1, 2, 3, 4 oder 5, wobei das Mittel zum lösbaren Anbringen ein Magnetmittel beinhaltet.

7. Gerät gemäß einem der vorhergehenden Ansprüche, wobei das Mittel zum lösbaren Anbringen einen Vakuumauslass zum Anziehen des Verschlussteils an das Flüssigkeitszufuhrsystem beinhaltet.

8. Gerät gemäß Anspruch 5 oder 7, wobei das Dichtungsteil eine Niederdruckquelle (14) zum Abdichten zwischen dem Dichtungsteil und dem Substrat oder dem Verschlussteil beinhaltet, wobei die Niederdruckquelle (14) mindestens einen Teil des Mittels zum lösbaren Anbringen bildet.

9. Gerät gemäß einem der Ansprüche 2 bis 8, wobei das Verschlussteil in einer verstauten Position eine primäre Oberfläche aufweist, die zu einer dem Endelement zugewandten Oberfläche des Substrats im Wesentlichen koplanar ist.

10. Gerät gemäß einem der Ansprüche 1 bis 9, wobei das Verschlussteil eine Markierung zum Führen des Verschlussteils beinhaltet.

11. Gerät gemäß Anspruch 10, die ferner einen Sensor zum Messen der Position des Verschlussteils unter Verwendung der Markierung beinhaltet.

12. Gerät gemäß einem der Ansprüche 1 bis 11, wobei das Verschlussteil (150) in dem Dichtungsteil positioniert ist, wenn es die Flüssigkeit eindämmt.

13. Gerät gemäß einem der vorhergehenden Ansprüche, wobei das Flüssigkeitszufuhrsystem ein Mittel zum Entfernen von Flüssigkeit aus dem Raum und einen Gaseinlass (17) zum Bereitstellen eines Spülgases in dem Raum beinhaltet.

14. Ein Verfahren zum Herstellen einer Vorrichtung, das die folgenden Schritte beinhaltet:
- Bereitstellen eines Substrats, das mindestens teilweise mit einer Schicht aus strahlungsempfindlichem Material überzogen ist;
- Bereitstellen eines Projektionsstrahls aus Strahlung unter Verwendung eines Strahlungssystems;
- Verwenden eines Musteraufbringungsmittels, um den Projektionsstrahl in seinem Querschnitt mit einem Muster zu versehen;
- Verwenden eines Flüssigkeitszufuhrsystems, um eine Immersionsflüssigkeit bereitzustellen, die einen Raum zwischen dem Endelement eines in dem Schritt des Projizierens verwendeten Projektionssystems und einem Substrat auf nur einem örtlich begrenzten Bereich des Substrats mindestens teilweise füllt, wobei das Flüssigkeitszufuhrsystem ein Dichtungsteil (12) beinhaltet, das sich entlang mindestens einem Teil einer Grenze des Raums erstreckt, um die Flüssigkeit einzugrenzen, und das eine Öffnung für das Durchgehen des Projektionsstrahls bildet;
- Projizieren des gemusterten Strahls aus Strahlung auf einen Zielabschnitt der Schicht aus strahlungsempfindlichem Material;
- Wegbewegen des Substrats von unter dem Projektionssystem;
- und Beibehalten des Endelements in Kontakt mit Flüssigkeit, nachdem das Substrat von unter dem Projektionssystem wegbewegt worden ist, indem die Öffnung des Dichtungsteils unter Verwendung eines Verschlussteils, welches von dem Rest des Geräts trennbar ist, abgedeckt wird und das Verschlussteil lösbar an dem Dichtungsteil angebracht wird.

15. Verfahren gemäß Anspruch 14, wobei der Kontakt des Endelements mit der Immersionsflüssigkeit beibehalten wird, indem das Verschlussteil auf einer Seite des Flüssigkeitszufuhrsystems, die dem Projektionssystem entgegengesetzt ist, positioniert wird, so dass die Immersionsflüssigkeit in dem Dichtungsteil und zwischen dem Projektionssystem und dem Verschlussteil eingedämmt wird.

## Revendications

1. Un appareil de projection lithographique comprenant :
- un système de rayonnement (LA, Ex, IL) destiné à fournir un faisceau de projection (PB) de rayonnement ;
- une structure formant support (MT) destinée à servir de support à un moyen pour conformer selon un motif (MA), le moyen pour conformer selon un motif servant à conformer le faisceau de projection selon un motif souhaité ;
- une table porte-substrat (WT) destinée à porter un substrat (W) ;
- un système de projection (PL) destiné à projeter le faisceau à motif sur une portion cible du substrat ; et
- un système d'alimentation en liquide sur zone localisée destiné à fournir un liquide d'immersion à un espace entre l'élément final dudit système de projection et ledit substrat sur une zone localisée seulement dudit substrat, **caractérisé en ce que** :
ledit système d'alimentation en liquide comprend un élément d'étanchéité (12) qui s'étend le long d'au moins une partie du pourtour dudit espace pour contenir ledit liquide et qui forme une ouverture pour que le faisceau de projection passe à travers, et **en ce que**
ledit appareil comprend en outre un élément obturateur (100, 150) destiné à garder ledit élément final en contact avec le liquide lorsque ledit substrat est déplacé de façon à ce qu'il ne se trouve plus sous ledit système de projection en recouvrant l'ouverture dudit élément d'étanchéité pour empêcher que le liquide ne s'échappe hors du système d'alimentation en liquide par l'ouverture, et où ledit élément obturateur est séparable du reste dudit appareil, et ledit appareil comprend en outre des moyens pour attacher de manière libérable (14, 15, 16, 160) ledit élément obturateur audit élément d'étanchéité.

2. L'appareil selon la revendication 1, où ledit élément obturateur est positionnable sur un côté dudit système d'alimentation opposé audit système de projection de telle sorte que ledit liquide d'immersion puisse être confiné dans ledit élément d'étanchéité et entre ledit système de projection et ledit élément obturateur.

3. L'appareil selon la revendication 1 ou la revendication 2, où ledit élément obturateur et / ou ladite table porte-substrat a ou ont des moyens pour tenir de manière libérable (157, 170) ledit élément obturateur sur ladite table porte-substrat.

4. L'appareil selon la revendication 3, où lesdits moyens pour tenir de manière libérable comprennent des moyens magnétiques.

5. L'appareil selon la revendication 3 ou la revendication 4, où lesdits moyens pour tenir de manière libérable comprennent un orifice de sortie à vide pour attirer ledit élément obturateur sur ladite table porte-substrat.

6. L'appareil selon la revendication 1, la revendication 2, la revendication 3, la revendication 4 ou la revendication 5, où lesdits moyens pour attacher de manière libérable comprennent des moyens magnétiques.

7. L'appareil selon l'une quelconque des revendications précédentes, où lesdits moyens pour attacher de manière libérable comprennent un orifice de sortie à vide pour attirer ledit élément obturateur sur ledit système d'alimentation en liquide.

8. L'appareil selon la revendication 5 ou la revendication 7, où ledit élément d'étanchéité comprend une source à basse pression (14) pour étanchéifier entre ledit élément d'étanchéité et ledit substrat ou ledit élément obturateur, ladite source à basse pression (14) formant au moins une partie desdits moyens pour attacher de manière libérable.

9. L'appareil selon l'une quelconque des revendications 2 à 8, où, dans une position rangée, ledit élément obturateur a une surface primaire substantiellement co-planaire avec une surface dudit substrat faisant face audit élément final.

10. L'appareil selon l'une quelconque des revendications 1 à 9, où ledit élément obturateur comprend une marque pour guider ledit élément obturateur.

11. L'appareil selon la revendication 10, comprenant en outre un capteur destiné à mesurer la position dudit élément obturateur à l'aide de ladite marque.

12. L'appareil selon l'une quelconque des revendications 1 à 11, où ledit élément obturateur (150), lorsqu'il confine ledit liquide, est positionné dans ledit élément d'étanchéité.

13. L'appareil selon l'une quelconque des revendications précédentes, où ledit système d'alimentation en liquide comprend des moyens pour retirer du liquide dudit espace et un orifice d'entrée de gaz (17) pour fournir un gaz de rinçage dans ledit espace.

14. Un procédé de fabrication de dispositif comprenant les étapes de :
- fournir un substrat qui est au moins partiellement recouvert d'une couche de matériau sensible au rayonnement ;
- fournir un faisceau de projection de rayonnement à l'aide d'un système de rayonnement ;
- utiliser un moyen pour conformer selon un motif afin de doter le faisceau de projection d'un motif dans sa coupe transversale ;
- utiliser un système d'alimentation en liquide afin de fournir un liquide d'immersion remplissant au moins partiellement un espace entre l'élément final d'un système de projection utilisé dans ladite étape de projection et un dit substrat sur une zone localisée seulement dudit substrat où ledit système d'alimentation en liquide comprend un élément d'étanchéité (12) qui s'étend le long d'au moins une partie d'un pourtour dudit espace pour contenir ledit liquide et qui forme une ouverture pour que le faisceau de projection passe à travers ;
- projeter le faisceau de rayonnement à motif sur une portion cible de la couche de matériau sensible au rayonnement ;
- déplacer ledit substrat de façon à ce qu'il ne se trouve plus sous ledit système de projection ;
- et maintenir ledit élément final en contact avec le liquide après avoir déplacé ledit substrat de façon à ce qu'il ne se trouve plus sous ledit système de projection en recouvrant l'ouverture dudit élément d'étanchéité à l'aide d'un élément obturateur, lequel est séparable du reste de l'appareil, et en attachant de manière libérable l'élément obturateur à l'élément d'étanchéité.

15. Le procédé selon la revendication 14, où ledit élément final est maintenu en contact avec ledit liquide d'immersion en positionnant ledit élément obturateur sur un côté dudit système d'alimentation en liquide opposé audit système de projection de telle sorte que ledit liquide d'immersion soit confiné dans ledit élément d'étanchéité et entre ledit système de projection et ledit élément obturateur.
